# EUROPÄISCHE PATENTSCHRIFT

(11) **EP 3 839 104 B1**
(45) Veröffentlichungstag und Bekanntmachung des Hinweises auf die Patenterteilung: **02.11.2022**
(21) Anmeldenummer: 20000460.4
(22) Anmeldetag: 11.12.2020
(51) Int. Cl.: C30B 25/16, C23C 16/30, C30B 25/18, C30B 29/40, C30B 29/42, H01L 21/02

(54) **GASPHASENEPITAXIEVERFAHREN**
GAS PHASE EPITAXY METHOD
PROCÉDÉ D'ÉPITAXIE EN PHASE GAZEUSE

(30) Priorität: 20.12.2019 DE 102019008930
(43) Veröffentlichungstag der Anmeldung: 23.06.2021
(73) Patentinhaber: AZUR SPACE Solar Power GmbH, 74072 Heilbronn (DE)
(72) Erfinder: Wächter, Clemens, 74348 Lauffen am Neckar (DE); Keller, Gregor, 74080 Heilbronn (DE); Fuhrmann, Daniel, 74081 Heilbronn (DE)
(74) Vertreter: Koch Müller Patentanwaltsgesellschaft mbH

(56) Entgegenhaltungen:
- EP-A2- 1 385 215
- US-A- 3 419 742
- US-A1- 2013 019 944

## Beschreibung

Es sind die unterschiedlichsten Gasphasenepitaxie-Anlagen, z.B. von der Fa. Aixtron, zum epitaktischen Erzeugen von Halbleiterschichten bekannt. Auch sind aus der EP 138 5215 A2, der US 3 419 742 A und der US 2013 019 944 A1 Gasphasenepitaxieanlagen bekannt.

Den Anlagen gemein ist, dass die epitaktischen Schichten aus der Gasphase auf einem in einer Reaktionskammer eingebrachten Substrat abgeschieden bzw. aufgewachsen werden. Hierzu wird die Reaktionskammer aufgeheizt und ein Epitaxie-Gasfluss in die Reaktionskammer eingeleitet.

Die Zusammensetzung des Gasflusses richtet sich nach der Art der zu wachsenden Schicht, wobei typischerweise Präkursoren, wie z.B. Arsin und/oder TMGa, die Elemente für die zu wachsende Halbleiterschicht liefern und für eine Dotierung der Schicht gegebenenfalls auch Präkursoren für einen Dotierstoff zugegeben werden. Die Präkursoren werden mittels eines Trägergases in die Reaktionskammer geleitet. Um die Zusammensetzung des Gasflusses zu kontrollieren werden typischerweise Massestromregler eingesetzt.

Zu beachten ist allerdings auch, dass aufgrund der Reaktorhistorie auch noch andere unerwünschte Elemente aus vorherigen Prozessen in der Reaktionskammer vorhanden sein können. Gerade für das Erzeugen niedrig dotierter Schichten kann dies problematisch werden.

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Gasphasenepitaxieverfahren mit dem Verfahrensschritt Aufwachsen einer III-V-Schicht mit einer sich von einem ersten Leitfähigkeitstyp zu einem zweiten Leitfähigkeitstyp ändernden Dotierung auf einer Oberfläche eines Substrats oder einer vorausgehenden Schicht bereitgestellt.

Der erste Leitfähigkeitstyp ist p und der zweite Leitfähigkeitstyp ist n.

In einer Reaktionskammer wird aus der Gasphase aus einem Epitaxie-Gasfluss die III-V-Schicht aufgewachsen.

Der Epitaxie-Gasfluss weist ein Trägergas und mindestens einen ersten Präkursor für ein Element aus der III. Hauptgruppe und mindestens einen zweiten Präkursor für ein Element aus der V. Hauptgruppe auf.

Das Element der III. Hauptgruppe ist Gallium, und das Element der V. Hauptgruppe ist Arsen.

Außerdem wird bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss und mit oder ohne Zugabe eines weiteren Präkursors für einen Dotierstoff des ersten Leitfähigkeitstyps zu dem Epitaxie-Gasfluss ein erster Dotierungsausgangswert des ersten Leitfähigkeitstyps eingestellt.

Anschließend wird durch treppenförmiges oder kontinuierliches Erhöhen eines Massestroms eines dritten Präkursors für einen Dotierstoff des zweiten Leitfähigkeitstyps und/oder durch treppenförmiges oder kontinuierliches Ändern des Verhältnisses zwischen dem ersten Massestrom und dem zweiten Massestrom eine Dotierung der III-V-Schicht über eine Übergangsbereichsschicht mit einer Aufwachshöhe von mindestens 10 µm treppenförmig oder kontinuierlich bis zu einem Erreichen eines Dotierungszielwerts des zweiten Leitfähigkeitstyps geändert wird.

Es versteht sich, dass eine III-V-Schicht mindestens eine Komponente der III. Hauptgruppe und mindestens eine Komponenten der V. Hauptgruppe aufweist, nämlich Gallium und Arsen, aber auch mehrere Elemente der III. und/oder V. Hauptgruppe, z.B. zusätzlich Indium, oder weitere Elemente anderer Gruppen aufweisen kann.

Als Präkursor werden Moleküle bezeichnet, welche als Ausgangsprodukt für das epitaktische Wachstum dienen. Ein Präkursor ist entsprechend ein Molekül bestehend aus einem aufzuwachsenden Element, z.B. einem Element der III. oder V. Hauptgruppe oder einem Dotierstoff, und mindestens einem weiteren Element. Insbesondere bei metallorganischen Präkursoren, z.B. TMGa, ist mindestens ein weiteres Element Kohlenstoff, welcher während des Aufwachsens freigesetzt wird und als Dotierstoff wirkt.

Wird ein Präkursor für einen Dotierstoff zugefügt, so spricht man von direkter Dotierung, während ein Dotieren mittels des Kohlenstoffs eines metallorganischen Präkursors als Autodoping bezeichnet wird.

Die Höhe sowie die Art der Dotierung einer III-V-Schicht ist auch von dem Mengenverhältnis zwischen dem Element der III. Hauptgruppe und dem Element der V. Hauptgruppe in der Reaktionskammer abhängig.

Je nach Art und Größe der verwendeten Gasphasen-Anlage schwankt dieses Mengenverhältnis innerhalb der Reaktionskammer, d.h. an unterschiedlichen Orten weist der ankommende Gasfluss unterschiedliche V-III-Mengenverhältnisse auf. Solche Schwankungen können im Bereich eines einzelnen Substrats und/oder über mehrere Substrate hinweg auftreten.

Es versteht sich, dass das Ändern des Massestroms oder das Ändern des Verhältnisses von zwei unterschiedlichen Masseströmen äquivalent mit dem Ändern eines entsprechen Partialdrucks bzw. Partialdruckverhältnisses bzw. grundsätzlich äquivalent mit jeder Mengenkontrolle/-änderung ist.

Es versteht sich auch, dass das Einstellen der genannten Dotierungswerte während des Aufwachsens geschieht bzw. dass durchgehend aufgewachsen wird und während des Wachsens bzw. Abscheidens die Masseströme geändert werden.

Zuerst wird der erste Dotierungsausgangswert des ersten Leitfähigkeitstyps eingestellt. Beispielsweise weist eine vorab gewachsene Schicht oder das Substrat eine Dotierung mit abnehmendem Verlauf auf, wobei bei der ersten Aufwachshöhe der erste Dotierungsausgangswert erreicht ist.

Durch die Änderung des Masseflusses des dritten Präkursors während des Wachsens der Übergangsbereichsschicht lässt sich ein reproduzierbarer Verlauf im Bereich des p-n Übergangs erzielen. Eine unerwünschte Ausbildung von seriellen mehrfach p/n Übergängen lassen sich auf den Halbleiterscheiben ebenso wie eine Ausbildung von lokalen Unterschieden in den Dotierstoffverläufen zuverlässig unterdrücken.

Ein weiterer Vorteil ist, dass sich eine Kreuzkontamination, beispielsweise aus der Belegung der Reaktorkammer aus vorangegangenen Epitaxiephasen, zuverlässig und wirkungsvoll kompensieren lässt und sich Schichten mit niedrigen Dotierungen unterhalb von 5•10¹⁵ cm⁻³ und insbesondere p / n Übergänge ausgehend von einer p-Dotierung zuverlässig herstellen lassen.

Ausgehend von einem konstanten V / III Verhältnisses während des Wachsens der Übergangsbereichsschicht von wenigstens 10 µm, lassen sich die bisherigen auf den Halbleiterscheiben stark schwankenden Sperrspannungen, mit Unterschieden von mehr als 20 Volt oder mehr als 100 V, reduzieren.

Anders ausgedrückt, lokale Dotierungsunterschiede auf der Halbleiterscheibe bedingt durch Schwankungen des V / III Verhältnisses und / oder bedingt durch unterschiedliche Hintergrunddotierungen in der Epitaxie-Anlage werden reduziert.

Alternativ weist die vorausgehende Schicht oder das Substrat bereits eine dem Dotierungsausgangswert entsprechende Dotierung auf, so dass sich das Einstellen bei Erreichen der ersten Aufwachshöhe auf einem Beibehalten der Einstellungen entspricht.

In einer weiteren Alternative weist die vorab gewachsene Schicht oder das Substrat eine höhere Dotierung auf, wobei die Dotierung sprunghaft, schrittweise oder kontinuierlich bis zu der ersten Aufwachshöhe auf den ersten Ausgangswert gesenkt wird.

Es versteht sich, dass eine sprunghafte Änderung eine Änderung der Dotierung ohne Zwischenschritte und über eine sehr geringe Aufwachshöhe, z.B. höchstens einige Nanometer, beschreibt.

Der Dotierungszielwert wird anschließend über eine Rampe oder Treppe, also eine kontinuierliche oder schrittweise Änderung der Dotierung in der aufwachenden Schicht über die Übergangsbereichsschicht hinweg erreicht.

Die Rampe oder Treppe schließt sich entweder direkt an, so dass sich die Dotierung direkt ausgehend von der ersten Aufwachshöhe ändert. Alternativ beginnt die Rampe oder Treppe zeitlich verzögert, so dass sich zwischen der ersten Aufwachshöhe und dem Beginn der Rampe oder Treppe eine Schicht mit konstanter Dotierung ausbildet.

Die Änderung der Dotierung über die Übergangsbereichsschicht erfolgt entweder ausschließlich durch eine Erhöhung des Massenstroms des dritten Präkursors, z.B. Silan, oder das Mengenverhältnis zwischen den Elementen der III. und V. Hauptgruppe, also zwischen dem ersten und zweiten Massestrom wird zusätzlich geändert. Gemäß einer weiteren Alternativen wird die Änderungen der Dotierung allein durch eine Änderung des Mengenverhältnisses zwischen den Elementen der III. und V. Hauptgruppe bewirkt.

Es versteht sich, dass der Epitaxie-Gasfluss auch bei dem Einstellen des ersten Dotierungsausgangswerts bereits einen gegebenenfalls geringen Massefluss des dritten Präkursors aufweisen kann, wobei die Präsenz des Dotierstoffs des zweiten Leitfähigkeitstyps mittels des V-III-Verhältnisses und/oder des Massestroms des weiteren Präkursors entsprechend ausgeglichen wird. Als Trägergase für die Epitaxie-Gasflüsse eignet sich beispielsweise H₂ oder N₂.

Aufgrund von örtlichen Unterschieden im V-III-Verhältnis und/oder von Hintergrunddotierungen kann ein sprunghafter p-n Übergang, also eine Änderung der Dotierung von p nach n ohne Zwischenschritte und über eine sehr geringe Aufwachshöhe, z.B. höchstens einige Nanometer, gerade bei niedrigen Dotierungen zu sehr unterschiedlichen Sperrspannungen über einzelne Halbleiterscheiben und/oder mehrere Halbleiterscheiben hinweg führen. Anders ausgedrückt, Schwankungen des V-III-Verhältnisses über die Halbleiterscheibe resultieren in unterschiedlichen lokalen Dotierungen und wirken sich gerade bei niedrigen Dotierungen besonders stark aus.

Ein Vorzug des Verfahrens besteht darin, dass sich das Gasphasenepitaxieverfahren unter Nutzung eines geringen Flusses des zweiten Präkursors für die Gruppe V durchführen lässt. Wird insbesondere für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Durch die schrittweise oder kontinuierliche Änderung der Dotierung über die Dicke einer Übergangsbereichsschicht bei einem konstanten oder nahezu konstanten V/III Verhältnis der Masseströme, wird dagegen ein über die gesamte Reaktionskammer hinweg reproduzierbarer Verlauf des p-n Übergangs auf der Halbleiterscheiber erreicht.

Die Unterschiede im ankommenden Gasfluss wirken sich lediglich auf die absolute Wachstumstiefe des Übergangs aus, wobei die Unterschiede in der absoluten Wachstumstiefe einen geringeren Einfluss auf die erreichten Sperrspannungen haben als ein nicht reproduzierbarer Dotierungsverlauf des p-n Übergangs.

Mittels eines Massestromreglers für den Massestrom des dritten Präkursors sowie Massestromreglern für die Masseströme des ersten und zweiten Präkursors lässt sich der erfindungsgemäße treppen- oder rampenförmige Übergangsbereich auf einfache und zuverlässige Weise kontrollieren bzw. umsetzen.

Ein Vorteil der Erfindung ist somit, dass auf einfache und reproduzierbare Weise ohne besondere Anforderungen an die verwendete GasphasenEpitaxie-Anlage zuverlässig hohe Spannungsfestigkeiten erreicht werden.

Gemäß einer Ausführungsform ist der erste Dotierungsausgangswert ein p-Dotierungsausgangswert und beträgt höchstens 5•10¹⁶ cm⁻³ oder höchstens 1•10¹⁶ cm⁻³ oder höchstens 1•10¹⁵ cm⁻³ oder höchstens 5•10¹⁴ cm⁻³. Alternativ ist der erste Dotierungsausgangswert ein n-Dotierungsausgangswert und beträgt höchstens 1•10¹⁵ cm⁻³ oder höchstens 5•10¹⁴ cm⁻³ oder höchstens 1•10¹⁴ cm⁻³. Als Startpunkt für die Rampe oder Treppe wird somit eine niedrige p-Dotierung oder sogar schon eine sehr niedriger n-Dotierungswert gewählt.

In einer anderen Ausführungsform beträgt der n-Dotierungszielwert höchstens 5•10¹⁶ cm⁻³ oder höchstens 1•10¹⁶ cm⁻³ oder höchstens 1•10¹⁵ cm⁻³ oder höchstens 5•10¹⁴ cm⁻³ oder höchstens 1•10¹⁴ cm⁻³. Die Rampe oder Treppe überstreicht somit einen Bereich niedriger Dotierungswerte.

Gemäß einer weiteren Weiterbildung beträgt die Aufwachshöhe des Übergangsbereichs mindestens 30 µm oder mindestens 60 µm.

In einer anderen Ausführungsform wird die Dotierung über die Übergangsbereichsschicht um höchstens 1•10¹³ cm⁻³ über 5 µm Aufwachshöhe geändert.

Gemäß einer weiteren Ausführungsform wird die Dotierung über die Übergangsbereichsschicht in mindestens vier Schritten geändert In weiteren Ausführungsformen ist der dritte Präkursor Monosilan.

In einer Weiterbildung wird nach dem Erreichen des n-Dotierungszielwerts über eine Aufwachshöhe ein zweiter n-Dotierungszielwert durch sprunghaftes Ändern des dritten Massestroms und/oder durch sprunghaftes Ändern des Verhältnisses des ersten Massestroms zu dem zweiten Massestrom eingestellt wird, wobei der zweite n-Dotierungszielwert größer als der n-Dotierungszielwert ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt von in einer Reaktionskammer angeordneten Substraten,
- Figur 2: ein Zusammenhang zwischen einer Dotierung und einem Verhältnis von Elementen der V. Hauptgruppe zu Elementen der III. Hauptgruppe während eine epitaktischen Wachstums,
- Figur 3: einen Dotierstoffkonzentrationsverlauf über eine gewachsene III-V-Schicht gemäß einer ersten erfindungsgemäßen Ausführungsform des Gasphasenepitaxieverfahrens,
- Figur 4: einen Dotierstoffkonzentrationsverlauf über eine gewachsene III-V-Schicht gemäß einer zweiten erfindungsgemäßen Ausführungsform des Gasphasenepitaxieverfahrens,
- Figur 5: Verlauf des Masseflusses des dritten Präkursors über die Aufwachshöhe.

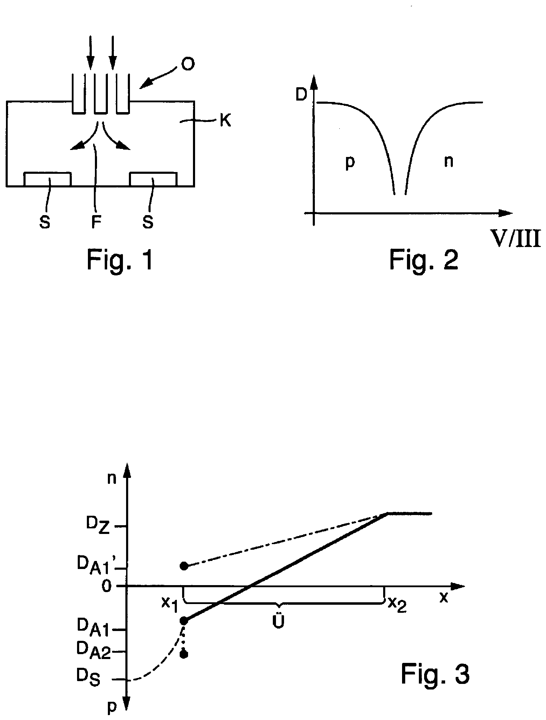

Die Abbildung der Figur 1 zeigt schematisch einen Querschnitt einer Reaktorkammer K einer Gasphasenepitaxie-Anlage. Auf einem Boden der Reaktorkammer K sind Substrate S angeordnet. Außerdem weist die Reaktorkammer K ein Gaseinlassorgan O auf, durch welches der Epitaxie-Gasfluss F In die Reaktorkammer K eingeleitet werden.

Der Epitaxie-Gasfluss F weist ein Trägergas, mindestens einen ersten metallorganischen Präkursor für ein Element der III. Hauptgruppe, z.B. TMGa, einen zweiten Präkursor für ein Element der V. Hauptgruppe, z.B. Arsin, und zumindest ab einer ersten Aufwachshöhe ×1 einen dritten Präkursor für einen n-Dotierstoff, z.B. Silan, auf.

Das Gaseinlassorgan O weist mehrere in der Reaktorkammer K endende Leitungen auf, durch welche jeweils eine Komponente oder mehrere Komponenten des Epitaxie-Gasflusses F zu der Reaktorkammer K geleitet werden.

In der Abbildung der Figur 2 ist in einem Diagramm die Abhängigkeit der Dotierung von einem Mengenverhältnis der Elemente der V. und III. Hauptgruppe aufgetragen. Insbesondere wird deutlich, dass nicht nur die Höhe einer Dotierung, sondern auch die Art der Dotierung, also n oder p, durch das V-III-Verhältnis, also das Mengenverhältnis in dem Gasfluss, eingestellt werden kann.

Andererseits wird deutlich, dass Schwankungen des V-III-Verhältnisses über einen Wafer bzw. ein Substrat zu unterschiedlichen Dotierungen führt und dass sich solche Schwankungen gerade bei niedrigen Dotierungen besonders stark auswirken.

Ein Vorzug dieser Ausgestaltung besteht darin, dass das Gasphasenepitaxieverfahren unter Nutzung eines geringen Flusses des zweiten Präkursors für die Gruppe V durchführen lässt. Insbesondere wird für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Eine erste Ausführungsform des erfindungsgemäßen Gasphasenepitaxieverfahrens ist in der Abbildung der Figur 3 anhand eines Verlaufs der Dotierung D über eine Aufwachshöhe x veranschaulicht.

Zuerst bzw. bei einer ersten Aufwachshöhe x₁ wird ein erster Dotierungsausgangswert D_{A1} des ersten Leitfähigkeitstyps LT1 mittels des Verhältnisses eines ersten Massestroms des ersten Präkursors, z.B. TMGa, zu einem zweiten Massestrom des zweiten Präkursor, z.B. Arsin, in dem Epitaxie-Gasfluss F und mit oder ohne Zugabe eines weiteren Massestroms eines weiteren Präkursors für einen Dotierstoff des ersten Leitfähigkeitstyps, z.B. Kohlenstofftetrabromid oder Dimethylzink, zu dem Epitaxie-Gasfluss F eingestellt.

Anschließend wird der dritte Massestrom des dritten Präkursors und/oder das Verhältnis zwischen dem ersten und zweiten Massestrom über eine Übergangsbereichsschicht Ü kontinuierlich geändert, bis bei einer zweiten Aufwachshöhe x₂ ein p-Dotierungszielwert D_{z} erreicht ist. Es versteht sich, dass sich der Übergangsschichtbereich Ü von der ersten Aufwachshöhe x₁ bis zur zweiten Aufwachshöhe x₂ erstreckt.

Anschließend wird der Epitaxie-Gasfluss F über einen weiteren Bereich der Aufwachshöhe x nicht weiter verändert, so dass die Dotierung der sich anschließenden III-V-Schlcht konstant bleibt. Alternativ (nicht dargestellt) wird die Dotierung im Anschluss an die Rampe nochmals sprunghaft auf einen zweiten Dotierungszielwert erhöht.

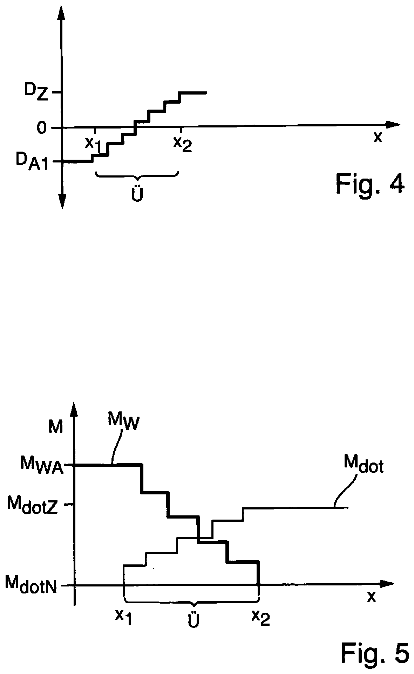

In der Abbildung der Figur 4 ist eine weitere Ausführungsform des erfindungsgemäßen Gasphasenepitaxieverfahrens anhand des Dotierungsverlaufs D veranschaulicht, wobei im Folgenden nur die Unterschiede zu den Abbildungen der Figuren 3 erläutert werden.

Die Änderung der Dotierung von dem n-Dotierungsausgangswert D_{A1} zu dem p-Dotierungszielwert D_{z} erfolgt in mehreren Schritten, so dass sich ein treppenförmiger Verlauf der Dotierung über die Übergangsbereichsschicht Ü einstellt.

In der Abbildung der Figur 5 ist eine weitere Ausführungsform des erfindungsgemäßen Gasphasenepitaxieverfahrens anhand eines Verlaufs des Massestroms M_{w} des weiteren Präkursors für einen p-Dotierstoff und des Massestroms M_{Dot} des dritten Präkursors für den n-Dotierstoff veranschaulicht.

Ausgehend von einem Massestromausgangswert M_{wa} zum Erreichen des p-Dotierungsausgangswerts D_{A1} wird der Massestroms M_{W} des weiteren Präkursors für einen p-Dotierstoff stufenförmig bei der Schichtdicke x₁ ab dem Wachstum der Übergangsbereichsschicht Ü reduziert, bis bei der Schichtdicke x₂ der Massefluss auf null oder nahe null reduziert ist. Hierdurch lässt sich der Dotierungsverlauf entsprechend der Figur 4 erzeugen.

Alternativ wird der Massestroms M_{W} des weiteren Präkursors für einen p-Dotierstoff kontinuierlich bei der Schichtdicke x₁ ab dem Wachstum der Übergangsbereichsschicht Ü reduziert, bis bei der Schichtdicke x₂ der Massefluss auf null oder nahe null reduziert ist. Hierdurch lassen sich die rampenförmigen Dotierungsverläufe entsprechend der Figur 3 erzeugen.

Es versteht sich, dass sich der Dotierungsverlauf auch stetig d.h. nicht rampenförmig einstellen lässt, indem der Massestrom des weiteren Präkursors entsprechend geändert wird.

In einer anderen Vorgehensweise wird ausgehend von einem Massestromausgangswert M_{dotN} bei null oder nahe null zum Erreichen des p-Dotierungsausgangswerts D_{A1} der Massestroms M_{dot} des dritten Präkursors für einen n-Dotierstoff stufenförmig bei der Schichtdicke x₁ ab dem Wachstum der Übergangsbereichsschicht Ü erhöht, bis bei der Schichtdicke x₂ der Massefluss den Zielwert M_{dotZ} erreicht. Hierdurch lässt sich der Dotierungsverlauf entsprechend der Figur 4 erzeugen.

Alternativ wird der Massestroms M_{dot} des dritten Präkursors für einen n-Dotierstoff kontinuierlich bei der Schichtdicke x₁ ab dem Wachstum der Übergangsbereichsschicht Ü erhöht, bis bei der Schichtdicke x₂ der Massefluss den Zielwert M_{dotZ} erreicht. Hierdurch lassen sich die rampenförmigen Dotierungsverläufe entsprechend der Figur 3 erzeugen.

Es versteht sich, dass sich der Dotierungsverlauf auch stetig d.h. nicht rampenförmig einstellen lässt, indem der Massestrom des dritten Präkursors entsprechend geändert wird.

Es versteht sich, dass sowohl der Massefluss des weiteren Präkursors als auch der Massefluss des dritten Präkursors sich gleichzeitig ändern lassen.

## Patentansprüche

1. Gasphasenepitaxieverfahren mit dem Verfahrensschritt:
Aufwachsen einer III-V-Schicht mit einer sich von einem ersten Leitfähigkeitstyp zu einem zweiten Leitfähigkeitstyp zweiten Leitfähigkeitstyp ändernden Dotierung (D) auf einer Oberfläche eines Substrats oder einer vorausgehenden Schicht in einer Reaktionskammer (K) aus der Gasphase aus einem Epitaxie-Gasfluss (F) aufweisend ein Trägergas, mindestens einen ersten Präkursor für ein Element aus der III. Hauptgruppe und mindestens einen zweiten Präkursor für ein Element aus der V. Hauptgruppe, wobei
das Element der III. Hauptgruppe Gallium und das Element der V. Hauptgruppe Arsen ist,
der erste Leitfähigkeitstyp p und der zweite Leitfähigkeitstyp n ist
- bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss (F) und mit oder ohne Zugabe eines weiteren Präkursors für einen Dotierstoff des ersten Leitfähigkeitstyps zu dem Epitaxie-Gasfluss (F) ein erster Dotierungsausgangswert (DA1) des ersten Leitfähigkeitstyps eingestellt wird und
- anschließend treppenförmiges oder kontinuierliches Erhöhen eines Massestroms eines dritten Präkursors für einen Dotierstoff des zweiten Leitfähigkeitstyps und/oder treppenförmiges oder kontinuierliches Ändern des Verhältnisses zwischen dem ersten Massestrom und dem zweiten Massestrom eine Dotierung (D) der III-V-Schicht über eine Übergangsbereichsschicht (Ü) mit einer Aufwachshöhe von mindestens 10 µm treppenförmig oder kontinuierlich bis zu einem Erreichen eines Dotierungszielwerts (DZ) des zweiten Leitfähigkeitstyps geändert wird.

2. Gasphasenepitaxieverfahren nach Anspruch 1, **dadurch gekennzeichnet, dass** der erste Dotierungsausgangswert (DA1) des ersten Leitfähigkeitstyps höchstens 5•10¹⁶ cm⁻³ oder höchstens 1•10¹⁶ cm⁻³ oder höchstens 1•10¹⁵ cm⁻³ oder höchstens 1•10¹⁴ cm⁻³ beträgt.

3. Gasphasenepitaxieverfahren nach Anspruch 1 oder 2, **dadurch gekennzeichnet, dass** der Dotierungszielwert (DZ) des zweiten Leitfähigkeitstyps höchstens 1•10¹⁵ cm⁻³ oder höchstens S•10¹⁴ cm⁻³ oder höchstens 1•10¹⁴ cm⁻³ beträgt.

4. Gasphasenepitaxieverfahren nach einem der vorstehenden Ansprüche, **dadurch gekennzeichnet, dass** die Aufwachshöhe des Übergangsbereichs mindestens 30 µm oder mindestens 60 µm beträgt.

5. Gasphasenepitaxieverfahren nach einem der vorstehenden Ansprüche, **dadurch gekennzeichnet, dass** die Dotierung (D) über die Übergangsbereichsschicht (Ü) um von höchstens 1•10¹³ cm⁻³ über 5 µm Aufwachshöhe (X) geändert wird.

6. Gasphasenepitaxieverfahren nach einem der vorstehenden Ansprüche, **dadurch gekennzeichnet, dass** die Dotierung (D) über die Übergangsbereichsschicht (Ü) in mindestens vier Schritten geändert wird.

7. Gasphasenepitaxieverfahren nach einem der vorstehenden Ansprüche, **dadurch gekennzeichnet, dass** der dritte Präkursor Monosilan ist.

8. Gasphasenepitaxieverfahren nach einem der vorstehenden Ansprüche, **dadurch gekennzeichnet, dass** nach dem Erreichen des n-Dotierungszielwerts (DZ) über eine Aufwachshöhe ein zweiter n-Dotierungszielwert durch sprunghaftes Ändern des dritten Massestroms und/oder durch sprunghaftes Ändern des Verhältnisses des ersten Massestroms zu dem zweiten Massestrom eingestellt wird, wobei der zweite n-Dotierungszielwert größer als der n-Dotierungszielwert (DZ) ist.

## Claims

1. Gas phase epitaxy method, comprising the method step:
- growing a III-V layer with a doping (D), which changes from a first type of conductivity to a second type of conductivity, on a surface of a substrate or a preceding layer in a reaction chamber (K) from the gas phase from an epitaxy gas flow (F) comprising a carrier gas, at least one first precursor for an element from the III main group and at least one second precursor for an element from the V main group,
wherein
the element of the III main group is gallium and the element of the V main group is arsenic, the first conductivity type is p and the second conductivity type is n
- on reaching a first growth height by means of a ratio of a first mass flow of the first precursor to a second mass flow of the second precursor in the epitaxy gas flow (F) and with or without addition of a further precursor for a doping substance of the first conductivity type to the epitaxy gas flow (F) a first doping start value (DA1) of the first conductivity type is set,
- subsequently through stepped or continuous increase in a mass flow of a third precursor and/or through stepped or continuous change in the ratio between the first mass flow and the second mass flow a doping (D) of the III-V layer is changed over a transition region layer (Ü) with a growth height of at least 10 µm in steps or continuously until reaching a doping target value (DZ) of the second conductivity type.

2. Gas phase epitaxy method according to claim 1, **characterised in that** the first doping start value (DA1) of the first conductivity type is at most 5·10¹⁶ cm⁻³ or at most 1·10¹⁶⁻ cm⁻³ or at most 1·10¹⁵ cm⁻³ or at most 1·10¹⁴ cm⁻³.

3. Gas phase epitaxy method according to claim 1 or claim 2, **characterised in that** the doping target value (DZ) of the second conductivity type is at most 1·10¹⁵ cm⁻³ or at most 5·10¹⁴ cm⁻³ or at most 1·10¹⁴ cm⁻³.

4. Gas phase epitaxy method according to any one of the preceding claims, **characterised in that** the growth height of the transition region is at least 30 µm or at least 60 µm.

5. Gas phase epitaxy method according to any one of the preceding claims, **characterised in that** the doping (D) is changed over the transition region layer (Ü) by at most 1·10¹³ cm⁻³ over 5 µm growth height (X).

6. Gas phase epitaxy method according to any one of the preceding claims, **characterised in that** the doping (D) is changed over the transition region layer (Ü) in at least four steps.

7. Gas phase epitaxy method according to any one of the preceding claims, **characterised in that** the third precursor is monosilane.

8. Gas phase epitaxy method according to any one of the preceding claims, **characterised in that** after reaching the n doping target value (DZ) over a growth height a second doping target value is set by abrupt change in the third mass flow and/or by abrupt change in the ratio of the first mass flow to the second mass flow, wherein the second n doping target value is greater than the n doping target value (DZ).

## Revendications

1. Procédé d'épitaxie en phase gazeuse comprenant l'étape suivant :
- croissance d'une couche III-V avec un dopage (D) variant d'un premier type de conductivité à un deuxième type de conductivité sur une surface d'un substrat ou d'une couche précédente dans une chambre de réaction (K) à partir de la phase gazeuse d'un flux de gaz d'épitaxie (F) présentant un gaz porteur, au moins un premier précurseur pour un élément du groupe III et au moins un deuxième précurseur pour un élément du groupe V,
selon lequel
l'élément du groupe III est du gallium et l'élément du groupe V de l'arsenic,
le premier type de conductivité est p et le deuxième type de conductivité n,
- lorsqu'une première hauteur de croissance est atteinte par le biais du rapport d'un premier flux massique du premier précurseur avec un deuxième flux massique du deuxième précurseur dans le flux de gaz d'épitaxie (F), avec ou sans ajout d'un autre précurseur pour un agent de dopage du premier type de conductivité dans le flux de gaz d'épitaxie (F), une première valeur de sortie de dopage (DA1) du premier type de conductivité est fixée,
- puis, en augmentant par incréments ou en continu un flux massique d'un troisième précurseur pour un agent de dopage du deuxième type de conductivité et/ou en modifiant par incréments ou en continu le rapport entre le premier flux massique et le deuxième flux massique, un dopage (D) de la couche III-V est modifié par incréments ou en continu par via une couche de zone de transition (Ü) d'une hauteur de croissance d'au moins 10 µm jusqu'à atteindre une valeur-cible de dopage (DZ) du deuxième type de conductivité.

2. Procédé d'épitaxie en phase gazeuse selon la revendication 1, **caractérisé en ce que** la première valeur de sortie de dopage (DA1) du premier type de conductivité est de 5•10¹⁶ cm⁻³ maximum ou de 1•10¹⁶ cm⁻³ maximum ou de 1•10¹⁵ cm⁻³ maximum ou 1•10¹⁴ cm⁻³ maximum.

3. Procédé d'épitaxie en phase gazeuse selon la revendication 1 ou 2, **caractérisé en ce que** la valeur-cible de dopage (DZ) du deuxième type de conductivité est de 1•10¹⁵ cm⁻³ maximum ou de 5•10¹⁴ cm⁻³ maximum ou de 1•10¹⁴ cm⁻³ maximum.

4. Procédé d'épitaxie en phase gazeuse selon une des revendications précédentes, **caractérisé en ce que** la hauteur de croissance de la zone de transition est d'au moins 30 µm ou d'au moins 60 µm.

5. Procédé d'épitaxie en phase gazeuse selon une des revendications précédentes, **caractérisé en ce que** le dopage (D) est modifié via la couche de zone de transition (Ü) de 1•10¹³ cm⁻³ maximum sur 5 µm de hauteur de croissance (X).

6. Procédé d'épitaxie en phase gazeuse selon une des revendications précédentes, **caractérisé en ce que** le dopage (D) est modifié via la couche de zone de transition (Ü) en au moins quatre incréments.

7. Procédé d'épitaxie en phase gazeuse selon une des revendications précédentes, **caractérisé en ce que** le troisième précurseur est du monosilane.

8. Procédé d'épitaxie en phase gazeuse selon une des revendications précédentes, **caractérisé en ce qu'**après avoir atteint la valeur-cible de dopage n (DZ) sur une hauteur de croissance, une deuxième valeur-cible de dopage n est fixée en modifiant brusquement le troisième flux massique et/ou en modifiant brusquement le rapport du premier flux massique avec le deuxième flux massique, la deuxième valeur-cible de dopage n étant supérieure à la valeur-cible de dopage n (DZ).
